Europäisches Patentamt

European Patent Office

Office européen des brevets

(11) Veröffentlichungsnummer: **0 185 976**
**A1**

(12) # EUROPÄISCHE PATENTANMELDUNG

(21) Anmeldenummer: **85115313.0**

(22) Anmeldetag: **03.12.85**

(51) Int. Cl.⁴: **H 03 K 17/945**
**H 02 H 3/06**

(30) Priorität: **21.12.84 DE 3446958**

(43) Veröffentlichungstag der Anmeldung:
**02.07.86 Patentblatt 86/27**

(84) Benannte Vertragsstaaten:
**CH DE FR IT LI**

(71) Anmelder: **Siemens Aktiengesellschaft**
**Berlin und München Wittelsbacherplatz 2**
**D-8000 München 2(DE)**

(72) Erfinder: **Schmitt, Manfred, Dipl.-Ing.**
**Bozener Strasse 4**
**D-8450 Amberg(DE)**

(54) **Anordnung zur Kurzschluss- bzw. Überlastüberwachung bei elektronischen Näherungsschaltern.**

(57) Durch die Erfindung soll eine Anordnung zur Kurz-schluß- bzw. Überlastüberwachung, insbesondere bei elektronischen Näherungsschaltern, geschaffen werden. Hierzu ist eine Stromerfassung im Ausgangskreis vorgesehen, die den Stromfluß durch Abschalten oder Begrenzen beeinflußt. Ein Abfragezyklus für die Stromerfassung mit einer Verzögerungszeit für die Beeinflussung und einer Wartezeit zwischen zwei Abfragen ist vorgesehen, wobei die Wartezeit wesentlich größer als die Verzögerungszeit ist, und lediglich die Länge der ersten Verzögerungszeit ist im Hinblick auf die Zeitkonstante der anzuschließenden Leitung gewählt. Hierdurch können Näherungsschalter mit längeren Anschlußleitungen realisiert werden, ohne daß die Leitungskapazität zu Fehlauslösungen der Kurzschlußsicherung führen und daß die Bauelemente entsprechend überdimensioniert werden müssen.

EP 0 185 976 A1

./...

FIG 5

Siemens Aktiengesellschaft      Unser **0185976**
Berlin und München      VPA **84**, - -

Anordnung zur Kurzschluß- bzw. Überlastüberwachung bei elektronischen Näherungsschaltern

Die Erfindung bezieht sich auf eine Anordnung zur Kurzschluß- bzw. Überlastüberwachung, insbesondere bei elektronischen Näherungsschaltern, durch Stromerfassung im Ausgangskreis und Beeinflussung des Stromflusses. Derartige Schaltungsanordnungen sind aus der DE-AS 21 49 063 für Wechselspannungsschalter bekannt. Insbesondere bei Dreileiternäherungsschaltern kann man bei Überschreiten des maximal zulässigen Laststromes den Ausgang des Näherungsschalters nach einer Verzögerungszeit abschalten und nach einer Wartezeit, die wesentlich größer ist als die Verzögerungszeit, wieder einschalten. Den Abfragezyklus kann man solange wiederholen, bis der Überlastzustand bzw. der Kurzschluß aufgehoben ist. Sollen jedoch mit derartigen Näherungsschaltern Lasten über lange Leitungen geschaltet werden, so kann selbst bei zulässigen Lastwerten der Abfragezyklus aufgrund einer Überlasterfassung eingeleitet werden, wenn eine zu kleine Verzögerungszeit gewählt wird. Der Grund hierfür liegt in der Leitungskapazität, die proportional zur Länge der Leitung ist. Diese Kapazität stellt im ersten Moment einen Kurzschluß für den Näherungsschalter dar, da die Kapazitäten durch den Ausgangsstrom aufgeladen werden müssen. Würde die Verzögerungszeit entsprechend groß gewählt, so wäre eine relativ große Verlustenergie für den Abfragezyklus aufzubringen, was meistens zu einer thermischen Überlastung der Schaltelemente führt. Um diese Belastung zu verhindern, könnte die Zykluszeit vergrößert werden, was die Schnelligkeit der Fehlererfassung nachteilig beeinflussen würde.

La 2 Syr / 26.09.85

**0185976**

Durch die Erfindung soll eine Anordnung der obengenannten Art geschaffen werden, die auch bei Verwendung längerer Leitungen kurzschlußfeste Ausgänge garantiert, ohne daß Bauelemente überdimensioniert werden müssen. Dies wird auf einfache Weise bei einer Anordnung der obengenannten Art dadurch erreicht, daß ein Abfragezyklus für die Stromerfassung mit einer Verzögerungszeit für die Beeinflussung und einer Wartezeit zwischen zwei Abfragen vorgesehen ist, wobei die Wartezeit wesentlich größer als die Verzögerungszeit ist und lediglich die Länge der ersten Verzögerungszeit im Hinblick auf die Zeitkonstande der anzuschliessenden Leitung gewählt ist. Eine einfache Erzeugung der unterschiedlichen Verzögerungszeit läßt sich erreichen, wenn die erste Verzögerungszeit als ganzzahliges Vielfaches der weiteren Verzögerungszeit gewählt ist. Hierzu ist es vorteilhaft, wenn zur Erzeugung der unterschiedlichen Verzögerungszeiten eine von einem Oszillator beeinflußte Teilerkette vorhanden ist. Um eine einwandfreie Zuordnung des Zustandes der einzelnen Bauteile zueinander zu garantieren ist es vorteilhaft, wenn ein Rücksetzimpuls bei Anlegen der Betriebsspannung für Oszillator, Teilerkette und zusätzliche bistabile Kippschaltungen vorgesehen ist. Mit einfachen handelsüblichen Bauelementen kann ausgekommen werden, wenn eine monostabile Kippschaltung für den Stromerfassungseingang und für den Freigabeausgang der Teilerkette vorgesehen ist und die bistabilen Kippstufen über UND-Gatter mit der Teilerkette in Verbindung stehen.

Anhand der Zeichnung wird ein Ausführungsbeispiel der erfindungsgemäßen Anordnung beschrieben und die Wirkungsweise näher erläutert.

Es zeigen:

Fig. 1 ein Stromspannungsdiagramm bei Auftreten eines Kurzschlusses bei Verwendung gleichgroßer Verzögerungszeiten,

Fig. 2 eine Stromspannungskurve zur Verdeutlichung der
Einwirkung einer kapazitiven Last,

Fig. 3 das Stromspannungsdiagramm zur Verdeutlichung der
minimal notwendigen Verzögerungszeit bei kapazitiver Last,

Fig. 4 die Stromspannungskurve bei Verwendung variabler
Verzögerungszeiten und

Fig. 5 eine Schaltungsmöglichkeit zur Erzielung der unterschiedlichen Verzögerungszeiten.

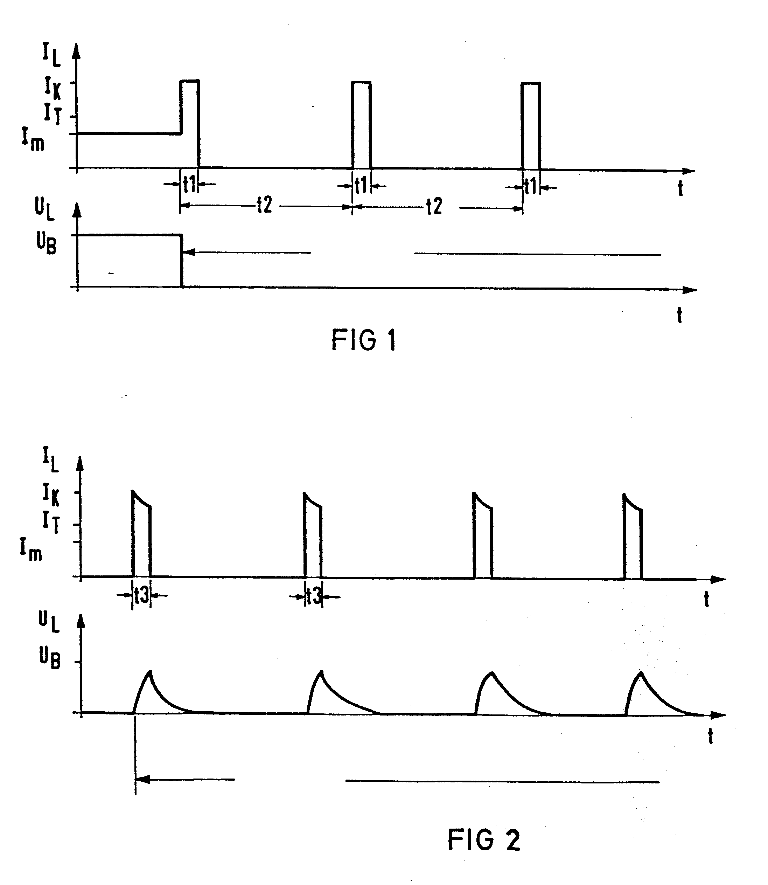

In den Diagrammen nach Fig. 1 bis 4 ist der Laststrom $I_L$
über der Zeit und die Lastspannung über der Zeit aufgetragen. Mit Imax ist der zulässige Laststrom bezeichnet.
$I_K$ ist der Kurzschlußstrom und $L_T$ ist der Strom bei
Takteinsatz.

Wie Fig. 1 zeigt, schaltet der Ausgang des Näherungsschalters nach der Verzögerungszeit t1 ab und nach der
Wartezeit t2, die wesentlich größer ist als die Zeit t1,
wird der Ausgang für die Zeit t1 wieder eingeschaltet.
Dies wiederholt sich, bis der Überlastzustand bzw. der
Kurzschluß aufgehoben ist. Im Diagramm nach Fig. 1 bleibt
der Kurzschluß bestehen. Fig. 2 zeigt den Zustand der
Überprüfung unter dem Einfluß der Leitungskapazität.
Diese Kapazität wirkt im ersten Moment als Kurzschluß für
den Näherungsschalter. Ist der Aufladevorgang des Kondensators bis zum Zeitpunkt t3 - siehe Fig. 2 - noch nicht
abgeschlossen, der Strom I hat fallende und die Spannung
U hat steigende Tendenz, so schaltet der Ausgang wieder
ab, obwohl kein Überlast- oder Kurzschlußfall vorliegt.
Würde man die Zeit t3 entsprechend groß wählen, so müßte
im echten Kurzschlußfall das Ausgangsschaltelement bei
jedem Abfragezyklus während der Zeit t3 die Verlustenergie
W1 tragen, die sich aus dem Produkt $W1 = t3 \times U_B \times I_K$
ergibt, $I_K$ Kurzschlußstrom, $U_B$ Betriebsspannung, t3 Verzögerungszeit.

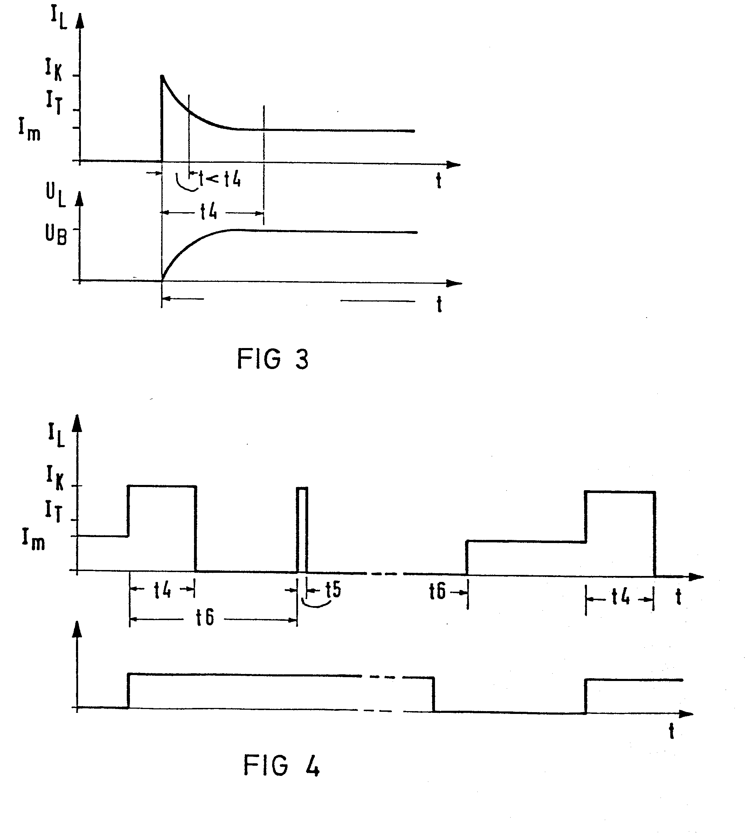

Nach Fig. 3 sollte für die Berücksichtigung der Kapazitäten eine erste Verzögerungszeit t4 gewählt werden. Hiernach ist der Strom unter den Strom bei Takteinsatz $I_T$ gesunken und liegt beim maximal zulässigen Laststrom und die Spannung hat die Betriebsspannung erreicht, d.h. es erfolgt keine Kurzschlußüberlastmeldung. Tritt hernach ein Kurzschlußfall auf - siehe Fig. 4 - so wird der erste Abfragezyklus über die Zeit t4, beispielsweise 200 µsec., durchlaufen. Die zweite Verzögerungszeit t5 wird auf den Wert $t5 = \frac{t4}{n}$ umgeschaltet und zwar nach der Wartezeit t6. Diese Zeit t5 gilt solange, bis kein Kurzschluß mehr festgestellt wird - siehe Fig. 4. Hiernach wird wieder auf die Zeit t4 zurückgeschaltet. Durch diese Maßnahme ist es möglich, die mittlere Verlustleistung im Kurzschlußfall um den Faktor $\frac{1}{n}$ zu reduzieren und damit die oben erwähnten Probleme weitgehend auszuschliessen, ohne jedoch die Zykluszeit t6 entsprechend vergrössern zu müssen.

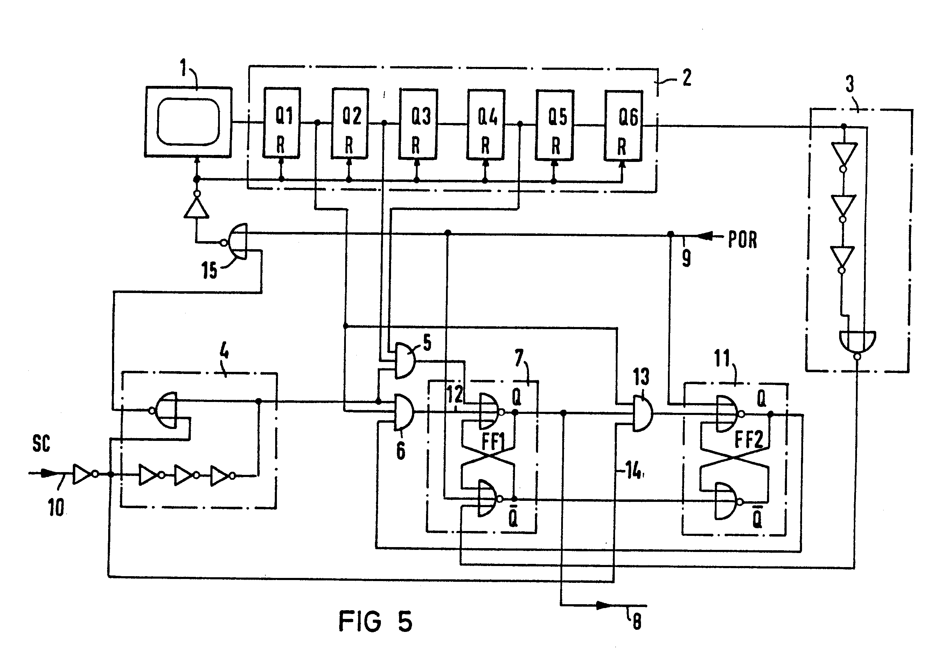

In Fig. 5 ist lediglich zur Realisierung der Erfindung auf den Schaltungsteil eingegangen, der die verschiedenen Verzögerungszeiten erzeugt. Die übliche Elektronik des Näherungsschalters, wie sie an sich bekannt ist, ist nicht näher dargelegt. Die Schaltung nach Fig. 5 besitzt einen Oszillator 1, der mit der Teilerkette 2 in Verbindung steht. Die Teilerkette besteht aus sechs Binärteilern Q1 bis Q6. Der Binärteiler Q6 ist mit der monostabilen Kippstufe 3 (one shot) mit dem Flip-Flop 7 in Verbindung gebracht, das einerseits mit der Freigabe 8 und andererseits über das UND-Gatter 13 mit dem Flip-Flop 11 in Verbindung steht. Das Flip-Flop 11 ist über das UND-Gatter 6 auf das Flip-Flop 7 rückgekoppelt. Das UND-Gatter 5 und das UND-Gatter 6 stehen mit den Binärausgängen der Teilerkette in Verbindung. Die monostabile Kippschaltung 4 leitet über den SC-Eingang den von der Stromerfassung abgegebenen Wert in die Schaltung ein. Der problemorientierte Routineeingang (POR, 9) sorgt für die Rücksetzung des Oszillators 1 und der Teilerkette 2 über ein UND-Gatter 15, sowie auch für die Flip-Flop 7 und 11 beim Einschalten der Netzspannung.

Wird über den POR-Eingang 9 ein Impuls auf den Oszillator 1 und die Teilerkette 2 sowie die Flip-Flop-Stufen 7 und 11 gegeben, so werden sie in einen definierten Zustand gebracht. Die monostabile Kippstufe 4 liefert bei Überlast- bzw. Kurzschlußmeldung am Eingang SC (SC-Pegel high) einen Impuls über das UND-Gatter 15, an dem bereits der Rückstellimpuls des Eingangs 9 anliegt, an den Oszillator 1 und die Teilerkette 2, wodurch diese zurückgesetzt und synchronisiert werden. Der Ausgang Q des Flip-Flop 11 führt low-Signal. Dadurch kann das Flip-Flop 7 erst nach Ablauf der Zeit t4 - siehe Fig. 4 - die von den Ausgängen Q2 und Q4 des Teilers 2 bestimmt werden, durch das Signal des Fühlereinganges 10 rückgesetzt werden, und der Näherungsschalterausgang wird durch low am Freigabeausgang 8 (output enable) blockiert. Gleichzeitig wird das Flip-Flop 11 gesetzt, d.h. Q = high. Die monostabile Kippstufe 3 aktiviert nach der Zeit t6, welche vom Ausgang Q6 der Teilerkette abgeleitet wird, das Flip-Flop 7 und gibt den Näherungsschalterausgang wieder frei. Wird nun erneut über den Eingang 10 ein Überlast- oder Kurzschlußfall festgestellt, kann das Flip-Flop 7 über das UND-Gatter 6 bereits nach der Zeit t5, die vom Ausgang Q1 der Teilerkette 2 abgeleitet wird, rückgesetzt werden. Dieser Zyklus Ausgang frei - Ausgang blockiert mit den Zeiten t5 und t6 wiederholt sich solange, bis kein Überlast- oder Kurzschlußfall mher festgestellt wird. Der Eingang 10 liegt auf low. Der Eingang des UND-Gatters 13 führt dann high-Signal und das Flip-Flop 11 wird nach der Zeit t5 zurückgesetzt. Damit ist der Ausgangszustand wieder hergestellt.

6 Patentansprüche 5 Figuren

Patentansprüche

1. Anordnung zur Kurzschluß- bzw. Überlastüberwachung, insbesondere bei elektrischen Näherungsschaltern, durch Stromerfassung im Ausgangskreis und Beeinflussung des Stromflusses, d a d u r c h  g e k e n n z e i c h - n e t , daß ein Abfragezyklus für die Stromerfassung mit einer Verzögerungzeit (t1, t4) für die Beeinflussung und einer Wartezeit (t2, t6) zwischen zwei Abfragen vorgesehen ist, wobei die Wartezeit (t2, t6) wesentlich größer als die Verzögerungszeit (t1, t4, t5) ist und lediglich die Länge der ersten Verzögerungszeit (t4) im Hinblick auf die Zeitkonstante der anzuschließenden Leitung gewählt ist.

2. Anordnung nach Anspruch 1, d a d u r c h  g e - k e n n z e i c h n e t , daß die erste Verzögerungs- zeit (t4) als ganzzahliges Vielfaches der weiteren Ver- zögerungszeit (t5) gewählt ist.

3. Anordnung nach Anspruch 1 oder 2, d a d u r c h  g e k e n n z e i c h n e t , daß zur Erzeugung der unterschiedlichen Verzögerungszeiten (t4, t5) eine von einem Oszillator (1) beeinflußte Teilerkette (2) vorhanden ist.

4. Anordnung nach einem der Ansprüche 1 bis 3, d a - d u r c h  g e k e n n z e i c h n e t , daß ein Rück- setzimpuls (9, POR) bei Anlegen der Betriebsspannung für Oszillator (1), Teilerkette (2) und zusätzliche bistabile Kippschaltungen (7, 11, FF) vorgesehen ist.

0185976

VPA 84 P 3537 E

5. Anordnung nach einem der vorhergehenden Ansprüche, d a d u r c h   g e k e n n z e i c h n e t ,   daß eine monostabile Kippschaltung (4, one shot) für den Stromerfassungseingang (10) und für den Freigabeausgang der Teilerkette (2) vorgesehen ist.

6. Anordnung nach einem der vorhergehenden Ansprüche, d a d u r c h   g e k e n n z e i c h n e t ,   daß die bistabilen Kippstufen (7, 11) über UND-Gatter (6, 13) mit der Teilerkette (2) in Verbindung stehen.

FIG 1

FIG 2

FIG 3

FIG 4

FIG 5

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int Cl 4) |
|---|---|---|---|
| Y | DE-A-3 111 659 (KASTL)<br>* Figur 3; Seite 21, Zeile 29 - Seite 22, Zeile 23 *<br><br>--- | 1 | H 03 K 17/945<br>H 02 H 3/06 |
| Y | DE-A-2 149 063 (KLASCHKA)<br>* Insgesamt *<br><br>--- | 1 | |
| A | DE-A-2 515 654 (KLASCHKA)<br>* Insgesamt *<br><br>--- | 1 | |
| A | DE-A-2 306 013 (SIEMENS)<br>* Figur 1; Anspruch 1 *<br><br>----- | 1 | |

| RECHERCHIERTE SACHGEBIETE (Int. Cl.4) |
|---|
| H 02 H<br>H 03 K |

Der vorliegende Recherchenbericht wurde für alle Patentansprüche erstellt.

| Recherchenort | Abschlußdatum der Recherche | Prüfer |
|---|---|---|
| DEN HAAG | 24-01-1986 | KOLBE W.H. |